(19) Europäisches Patentamt European Patent Office Office européen des brevets

(11) **EP 4 323 738 B1**

(12) **EUROPEAN PATENT SPECIFICATION**

(45) Date of publication and mention
of the grant of the patent:
**03.06.2026 Bulletin 2026/23**

(21) Application number: **22720830.3**

(22) Date of filing: **08.04.2022**

(51) International Patent Classification (IPC):
**G01K 7/42** $^{(2006.01)}$

(52) Cooperative Patent Classification (CPC):
**G01K 7/42**

(86) International application number:
**PCT/US2022/024002**

(87) International publication number:
**WO 2022/221134 (20.10.2022 Gazette 2022/42)**

(54) **TECHNIQUE FOR ESTIMATION OF INTERNAL BATTERY TEMPERATURE**

VERFAHREN ZUR SCHÄTZUNG DER TEMPERATUR EINER INTERNEN BATTERIE

TECHNIQUE D'ESTIMATION DE LA TEMPÉRATURE INTERNE D'UNE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.04.2021 US 202163174623 P
14.04.2021 US 202163174646 P
07.04.2022 US 202217715686**

(43) Date of publication of application:
**21.02.2024 Bulletin 2024/08**

(73) Proprietor: **Analog Devices, Inc.
Wilmington, MA 01887 (US)**

(72) Inventors:
• **TANOVIC, Omer
Wilmington, Massachusetts 01887 (US)**
• **RAMAN, Ravi Kiran
Wilmington, Massachusetts 01887 (US)**
• **YAUL, Frank
Wilmington, Massachusetts 01887 (US)**
• **GULLAPALLI, Hemtej
Wilmington, Massachusetts 01887 (US)**
• **SOLTANMOHAMMADI, Erfan
Wilmington, Massachusetts 01887 (US)**

(74) Representative: **Hunter, Christopher Jack Owen
Withers & Rogers LLP
2 London Bridge
London SE1 9RA (GB)**

(56) References cited:
**WO-A1-97/34133     US-A1- 2016 079 633**

**Description**

FIELD OF THE DISCLOSURE

This disclosure relates generally to battery temperature monitoring and, more particularly, to a technique for estimating battery internal temperature under thermally dynamic conditions.

US 2016/079633 A1 discloses systems and methods for estimating the average temperature of a battery pack using an extended Kalman filter. Said systems and methods include receiving battery system temperature measurement data from one or more temperature sensors associated with the battery system and ambient temperature measurement data associated with an ambient temperature proximate to the battery system. Based on the battery system temperature measurement data, the ambient temperature measurement data, an energy balance process model associated with the battery system, and a temperature parameter an average estimated temperature of the battery system is determined.

BRIEF DESCRIPTION OF THE DRAWINGS

To provide a more complete understanding of the present disclosure and features and advantages thereof, reference is made to the following description, taken in conjunction with the accompanying figures, wherein like reference numerals represent like parts, in which:

FIG. 1 is a simplified block diagram illustrating an example system for estimating internal battery temperature in accordance with features of embodiments described herein

FIG. 2 is a simplified block diagram of another example system for estimating internal battery temperature in accordance with features of embodiments described herein;

FIG. 3 is a simplified block diagram of an internal battery temperature estimator for use in example systems for estimating internal battery temperature in accordance with features of embodiments described herein;

FIG. 4 illustrates a lumped thermal model of a cylindrical pouch battery cell in connection with example systems for estimating internal battery temperature in accordance with features of embodiments described herein;

FIG. 5 is a simplified block diagram of yet another example system for estimating internal battery temperature in accordance with features of embodiments described herein;

FIG. 6 illustrates a model of an expanded lumped thermal model of a battery cell in connection with example systems for estimating internal battery temperature in accordance with features of embodiments described herein;

FIG. 7 is a flow diagram illustrating operation of an undersampled Kalman Filter for use in example systems for estimating internal battery temperature in accordance with features of embodiments described herein;

FIG. 8 is a flow diagram illustrating a method for adapting a measurement error covariance matrix employed in example systems for estimating internal battery temperature in accordance with features of embodiments described herein; and

FIG. 9 is a block diagram of a computer system that may be used to implement all or some portion of the system for estimating an internal temperature of a battery using impedance measurements in accordance with features of embodiments described herein.

DETAILED DESCRIPTION OF EXAMPLE EMBODIMENTS

*Overview*

Lithium-ion (Li-ion) batteries are rechargeable batteries that are commonly used for portable electronics and electric vehicles (EVs), as well as a variety of other applications, such military and aerospace applications. In order to monitor and maximize the performance of lithium-ion batteries, it is critical to monitor the internal temperature of such batteries during a variety of operations, such as fast charge and rapid discharge operations. Continuous monitoring of Li-ion batteries is required in order to prevent premature battery failure and to prolong their useful life. Extreme temperature (especially high temperature) is a main cause of damage to a Li-ion battery.

The development of EVs has been progressing rapidly and ensuring thermal safety of larger battery packs used to power such EVs is essential. The internal temperature of EV batteries has previously been monitored using thermal sensors, such as thermocouples, placed on the surface of the battery to monitor the surface temperature of the battery. This solution is non-ideal due to the delay in heat conductivity from the battery's internal core to the surface temperature, as well as the cost and complexity of implementing the necessary thermocouple network in connection with the battery. Additionally, due to stringent EV battery pack space limitations, there are typically only a few surface sensors per dozens of battery cells. As previously noted, battery cell temperature as measured using a surface thermocouple may differ significantly from the actual temperature at the inside of the battery due to delay in heat conductivity through the body of the battery, from the inside to the surface, as well as to battery self-heating, for example. In certain use cases, a greater than 15° C temperature gradient may exist across a cell body (e.g., from core to surface in cylindrical cells or from one side to the other in long prismatic cells); therefore, battery management systems that deploy a limited number of sensors are not capable of implementing effective thermal monitoring solutions.

Systems have been developed to measure electrical impedance of EV batteries using electrochemical impedance spectroscopy (EIS), which is strongly affected by the electrochemical activity within the battery and is well-correlated with battery temperature. Improvements in battery temperature estimation (e.g., using EIS) may enable more aggressive use of an EVs battery, effectively improving performance of the overall EV power train, and would provide benefits such as faster charging and improved EV acceleration and braking while extending battery life.

Currently, there is no reliable technology to measure internal temperature of rechargeable Li-ion batteries. For example, internal temperature may be the temperature of some specific point inside the battery or may be the hottest point inside the battery. In some examples, internal temperature may represent temperatures of multiple points inside a battery or a combination thereof. In particular, because of the way battery data (i.e., impedance and temperature) is typically collected, techniques that directly map impedance to internal battery temperature actually estimate average internal battery temperature instead, due to the above-described issues with respect to the large size of EV batteries.

In accordance with features of embodiments described herein, the internal temperature of a Li-ion rechargeable battery, such as an EV battery, may be estimated using data obtained using EIS measurement technology. In some embodiments, internal temperature of batteries such as Li-ion batteries, may be tracked using a KF-based technique that incorporates regression-based estimates of average battery temperature. The KF extension enables accurate measurement of internal temperature of large form factor batteries with non-negligible internal temperature gradients and enables interpolation of low sample rate temperature estimates obtained directly from EIS.

In accordance with features of embodiments described herein, lumped thermal models may be used to characterize the temperature of a battery over time and may be used to approximate the dynamics of battery temperatures.

*Example Systems for Estimating Internal Battery Temperature*

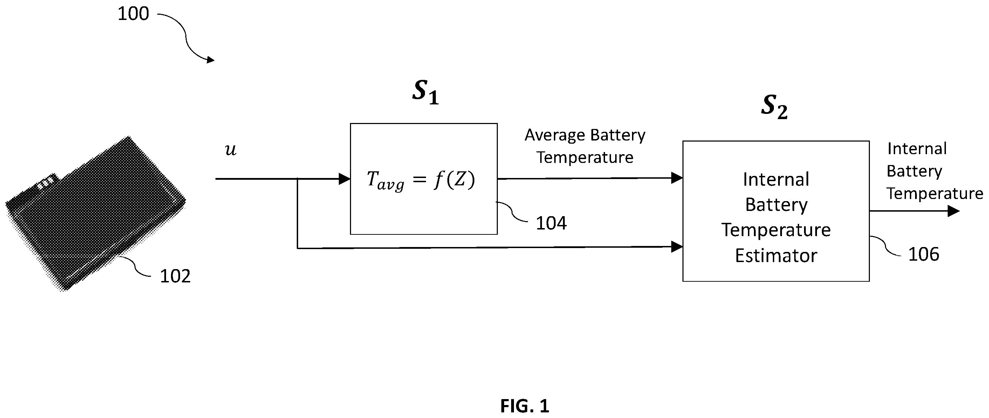

FIG. 1 is a block diagram of a system 100, which may be part of a battery management system (BMS), for estimating the internal temperature of a battery (such as an EV battery) in accordance with features of embodiments described herein. As shown in FIG. 1, system input (u) is an observable quantity input to the system 100 and may include one or more parameters of a system or device-under-test (DUT), represented in FIG. 1 as a DUT 102. Such parameters may include but are not limited to voltage, current, impedance, surface temperature, state-of-charge (SOC), battery coolant temperature, etc. Such parameters may be either directly measured or provided from some other part of the system under consideration. For example, SOC measurement may be provided by a central BMS.

As illustrated in FIG. 1, system input u is provided to a first system 104, which determines the average battery temperature ($T_{avg}$) from the system input. The average battery temperature output from the first system 104 is input along with the system input u to a second system 106 comprising an internal battery temperature estimator, which estimates the internal battery temperature from the values input thereto in a manner that will be described in greater detail below.

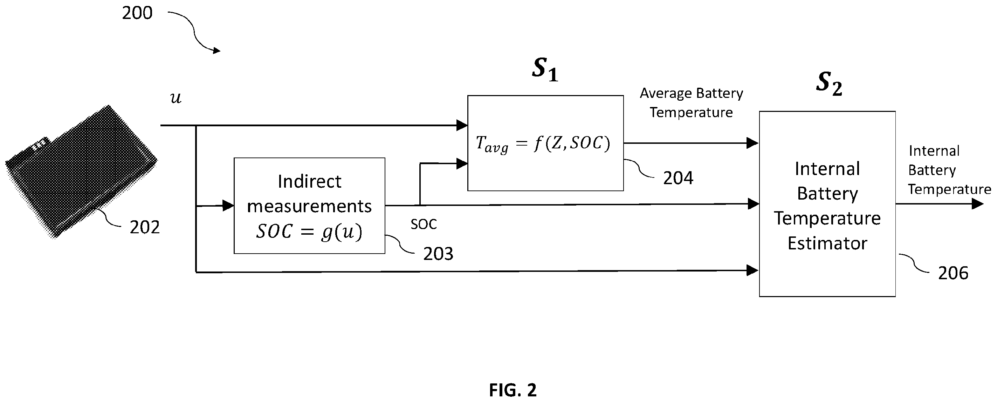

FIG. 2 illustrates a block diagram of a system 200 for estimating the internal temperature of a battery (such as an EV battery) in accordance with features of alternative embodiments described herein. As shown in FIG. 2, system input u is an observable quantity input to the system 200 and may include one or more parameters of a system or DUT, represented in FIG. 2 as a DUT 202. As noted above, such parameters may include but are not limited to voltage, current, impedance, surface temperature, SOC, battery coolant temperature, etc. As also noted above, such parameters may be either directly measured or provided by some other part of the system under consideration.

As illustrated in FIG. 2, a signal of interest (e.g., SOC) may be obtained as an indirect measure of the observable quantity u (e.g., SOC = g(u)), as designated by a reference numeral 203. The observable quantity u and indirect measurement SOC are input to a first system 204, which determines the average battery temperature ($T_{avg}$) from the observable quantity and the indirect measurement. The average battery temperature output from the first system 204 is input along with the observable quantity u and the indirect measurement SOC to a second system 206 comprising an internal battery temperature estimator, which estimates the internal battery temperature from the values input thereto in a manner that will be described in greater detail below.

*Example Internal Battery Temperature Estimator*

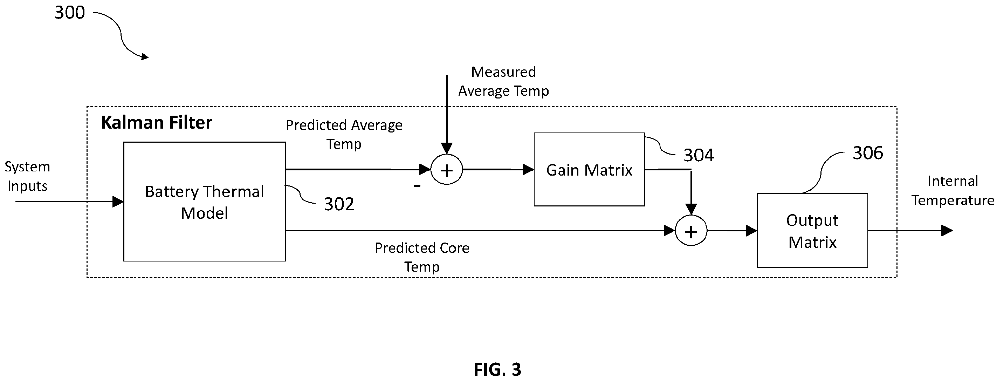

FIG. 3 is a block diagram of an internal battery temperature estimator 300 in accordance with features of embodiments described herein. As described herein, the estimator 300 may be implemented as a Kalman Filter (KF) or any other type of estimator, such as an extended KF, a particle filter, a dual KF, etc. The choice of estimator may depend on the battery thermal model under consideration, the rate at which the estimator needs to provide an estimate, computational resources, etc. As shown in FIG. 3, the internal battery temperature estimator 300 includes a battery thermal model 302 for receiving one or more system inputs and outputting a predicted average temperature and a predicted internal temperature based on the system input(s). The predicted average temperature is combined with measured average temperature for the battery and the result is input to a gain matrix 304. The output of the gain matrix is combined with the predicted internal temperature and the result is input to an output matrix 306. The output of the output matrix is the internal temperature estimate.

In order to track internal battery temperature, an internal battery temperature estimator, such as the estimator 300, may include a battery thermal model, such as battery thermal model 302, that describes the dynamics of the internal battery temperature in relation to other signals of interest (e.g., system input, observables, and/or other system states, such as surface battery temperature).

*Thermal Model Example*

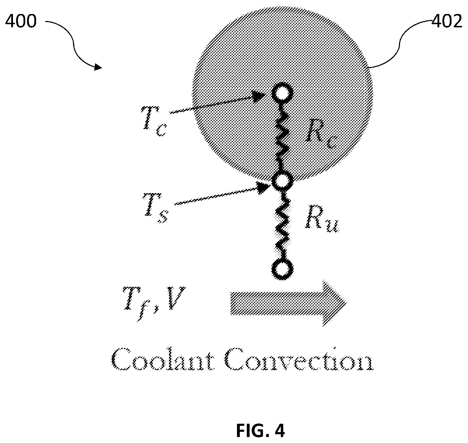

FIG. 4 illustrates a lumped thermal model 400 of a cylindrical pouch cell 402. In accordance with features of embodiments described herein, temperatures across the body of the cell 402 are lumped into the core temperature $T_c$ (i.e., internal temperature of the physical core of the battery) and surface temperature $T_s$.

The lumped thermal model 400 represents a linear dynamical system that approximates temperature evolution in the cell 402, which in an example embodiment may be a small 3AH cell. Given the small dimensions of the cell 402, it is sufficient to combine, or "lump," temperatures for the cell of interest into a core temperature ($T_c$), a surface temperature ($T_s$), and an ambient temperature ($T_e$), as shown in FIG. 4.

Given a current (I) drawn from the cell 402 and an environmental ambient temperature of $T_e$, the core temperature $T_c$ and surface temperature $T_S$ of the cell 402 may be defined using a battery thermal model such as:

$$C_c \frac{dT_c(t)}{dt} = I^2(t)R_e - I(t)T_c(t)\frac{\Delta S}{nF} + \frac{T_s(t) - T_c(t)}{R_c}, \qquad (1)$$

$$C_s \frac{dT_s(t)}{dt} = \frac{T_c(t) - T_s(t)}{R_s} - \frac{T_s(t) - T_c(t)}{R_c}. \qquad (2)$$

where $C_c$ and $C_s$ are the heat capacities of the core and surface of the cell 402, respectively, in units of joules per kelvin (J/K). $R_c$ and $R_s$ (also denoted $R_u$) are the thermal resistances between the cell core and cell surface and between the cell surface and the environment, respectively, in units of kelvin per watt (K/W ). $R_e$ is the internal resistance of the cell 402 in units of ohms ($\Omega$), $\Delta S$ is the change in entropy resulting from the cell reaction, F is the Faraday constant (96,485.33 sA/mol), and n is the number of electrons transferred in the chemical reaction of the cell 402. The model is a second order state space model with two states being the battery core temperature $T_c$ and the battery surface temperature $T_s$. Inputs are cell DC current I and coolant fluid temperature $T_f$. In equation (1) above, $I^2(t)R_e$ is the resistive heat generated in the cell 402, whereas $-I(t)T_c(t)\Delta S/nF$ is the heat resulting from the entropy change in the cell 402. As represented in equation (1), the core is warmed by the heat generated in the cell and cooled by the heat dissipated from the core to the surface (if the core is warmer than the surface). Similarly, equation (2) relates the change in surface temperature to the balance between the heat dissipation between the surface and the environment and between the surface and the environment. If a coolant fluid at a temperature of $T_f$ is used, the temperature of the environment may be replaced by the temperature of the coolant in equation (2). To simplify the model, the core temperature in equation (1) may be replaced by a constant average ambient temperature.

The model defined by equations (1) and (2) is a continuous time-state space model and must be discretized (e.g., using the forward Euler method) in order to be implemented on a digital device, such as a microcontroller (MCU) or field-programmable gate array (FPGA). The discretized state space model may be described as follows. The state may be represented by $x[n] = [T_c[n], T_s[n]]^T$ and the input signal may be represented by $u[n] = [I^2[n], I[n], T_e[n]]^T$. The thermal model described above may be discretized, resulting in the following equation that relates the $(n + 1)^{th}$ samples of temperatures to the measurements of the $n^{th}$ sample:

$$x[n + 1] = Ax[n] + Bu[n] \qquad (3)$$

where

$$A = \begin{bmatrix} 1 - \frac{\Delta t}{C_c R_c} & \frac{\Delta t}{C_c R_c} \\ \frac{\Delta t}{C_s R_c} & 1 - \frac{\Delta t}{C_s R_c} - \frac{\Delta t}{C_s R_s} \end{bmatrix} \tag{4}$$

and

$$B = \begin{bmatrix} \frac{R_e \Delta t}{C_c} & \frac{T_c \Delta S \Delta t}{nF} & 0 \\ 0 & 0 & \frac{\Delta t}{C_s R_s} \end{bmatrix} \tag{5}$$

In order to be used within a state estimator, the unknown model parameters $R_e$, $R_e$, $C_c$, $R_s$, and $C_s$, must be determined. For example, these model parameters may be precomputed offline based on a database of input-output battery data from the same type of cell and then ported into the algorithmic model. Alternatively, the unknown parameters may be estimated *in situ* by measuring the corresponding system inputs and outputs offline prior to using the model for temperature estimation and applying one of many conventional model parameter estimation methods. In yet another alternative, a Least Square (LS) method (either ordinary LS or generalized LS) may be used to estimate the model parameters *in situ*. In order to use the LS method, the system of equations for the discretized thermal battery model (equations (4) and (5)) should be rewritten in the form of one difference equation of the 2nd order, wherein the only variables that remain are the ones that can be measured (e.g., inputs I and $T_f$ and appropriate system outputs). System outputs are commonly chosen to be either some of the system states or some function of the states (based on what can be measured in the system).

In a conventional method, battery surface temperature $T_s$ is used as the measurable output and the thermal model state space equations are written as a second order difference equation with measurable inputs I and $T_f$ and a measurable output $T_s$. In many applications (e.g., automotive, energy storage systems (ESS), industrial), rechargeable Li-ion batteries are assembled in larger groups (e.g., modules or packs). In this case, it is not common to have surface thermal sensors on each cell, due to cost and other considerations; therefore, assuming that every cell that has to be modeled and monitored has a surface thermal sensor is very limiting. For that reason, model parameter estimation methods in accordance with features of embodiments described herein rely on other measurements that may be indirectly used as system outputs.

For example, an average cell temperature $T_{avg}$ that is indirectly measured (i.e., estimated) from cell impedance Z can be used in the embodiments described herein. In order to do this, the thermal model above may be supplied with an output equation that relates system states ($T_s$ and $T_c$) with the measurable signal $T_{avg}$. The relationship may be as simple as $T_{avg} = 0.5 T_s + 0.5 T_c$. Now the equations (4) and (5) along with this relationship make a system of three (difference-algebraic) equations with three unknowns: $T_s$, $T_c$ and $T_{avg}$. This system of equations may be reduced to one difference equation of the 2nd order that only contains terms with I, $T_f$, and $T_{avg}$, as shown below:

$$\begin{aligned} c_1\big(-2T_{avg}[k] + 2T_{avg}[k-1]\big) &+ c_2\big(-2T_{avg}[k-1] + 2T_f[k-1]\big) + c_3\big(T_f[k] - T_f[k-1]\big) \\ &+ c_4\big(I^2[k] - I^2[k-1]\big) + c_5 I^2[k-1] \\ &= 2\big(T_{avg}[k+1] - 2T_{avg}[k] + T_{avg}[k-1]\big) \end{aligned} \tag{A}$$

where parameters $c_1$-$c_5$ are functions of the original model parameters $R_e$, $R_c$, $C_c$, $R_s$, and $C_s$.

For example, if measurement $T_s$ is also available, the following equations may be used:

$$\begin{aligned} a\big(2T_s[k-1] - 2T_{avg}[k-1]\big) &+ bI^2[k-1] \\ &= \big(2T_{avg}[k] - T_s[k]\big) - \big(2T_{avg}[k-1] - T_s[k-1]\big) \end{aligned} \tag{B}$$

$$\begin{aligned} \frac{1}{c}\big(-T_s[k] + T_s[k-1]\big) &+ \frac{d}{c}\big(T_f[k-1] - T_s[k-1]\big) \\ &= \big(2T_s[k-1] - 2\overline{T}[k-1]\big) \end{aligned} \tag{C}$$

where parameters a, b, c, and d are functions of the original model parameters $R_e$, $R_e$, $C_c$, $R_s$, and $C_s$. The original model parameters $R_e$, $R_e$, $C_c$, $R_s$, and $C_s$ may then be calculated from the estimated parameters $c_1$-$c_5$ (or a, b, c, and d, depending on the available measurements) using the LS method. It may be noted that in equation (B), the right-hand side quantity at time k $((2T_{avg}[k] - T_s[k]) - (2T_{avg}[k-1] - T_s[k-1]))$ and the right-hand side quantity at time k+1 $((2T_{avg}[k+1] - T_s[k-1]) - (2T_{avg}[k] - T_s[k]))$ are correlated. Therefore, to solve, the variable may be whitened by multiplying both sides by the inverse of the covariance matrix of the variable defined by:

$$\Lambda = \begin{bmatrix} 2 & -1 & 0 & & & & & & \\ -1 & 2 & -1 & 0 & & & & & \\ 0 & -1 & 2 & -1 & 0 & & & & \\ & 0 & -1 & 2 & -1 & 0 & & & \\ & & & & \ddots & & & & \\ & & & & 0 & -1 & 2 & -1 & 0 \\ & & & & & 0 & -1 & 2 & -1 \\ & & & & & & 0 & -1 & 2 \end{bmatrix}$$

For simplicity, for every linear equation discussed herein, y denotes the free variables (right-hand side in equations (B) and (C)) $\beta$ denotes unknown model parameters, and X denotes independent variables. Therefore, the solution for equation (B) would be the following equation, known as the generalized least square (GLS) solution:

$$\beta = (X^{\mathsf{T}}\Lambda^{-1}X)^{-1}X^{\mathsf{T}}\Lambda^{-1}y$$

while the solution for equation (C) would be the following equation, known as the ordinary least squares (OLS) function:

$$\beta = (X^{\mathsf{T}}X)^{-1}X^{\mathsf{T}}y$$

after which c and d may be found using simple arithmetic.

Physical properties of the battery change over time, due to aging of the battery; therefore, the parameters of the battery thermal model changes. For that reason, calibration of parameters may need to be performed over the course of the battery life to adjust for changes. Model parameters that change with battery aging vary very slowly over the life of the battery. On the other hand, some parameters of the model depend on other parts of the system. For example, the parameter that represents heat convection between the battery and surrounding coolant fluid depends on the properties of the coolant fluid. Such parameters have to be tracked online and the model must be updated accordingly.

For example, if it is assumed that one cell in a battery pack is equipped with a surface temperature sensor and that coefficient c is fixed, d can be found using the following equation:

$$d\big(T_f[k-1] - T_s[k-1]\big) = T_s[k] - T_s[k-1] + c\big(2T_s[k-1] - 2T_{avg}[k-1]\big)$$

The above equation may be written in the form of y=dx, where the independent variable x, parameter d, and dependent variable y are all scalars. To identify the parameter adaptively, the normalized least mean square (NLMS) approach may be used as follows:

$$e[k] = y[k] - bx[k]$$

$$d[k] = d[k] + \frac{\mu}{\epsilon + x^2[k]} x[k]e[k]$$

Unlike d, parameter b should be identified for each cell individually and since it cannot be assumed that each cell has a surface temperature sensor, dependency on surface temperature should be eliminated (assuming coolant temperature changes much more slowly than other signals):

$$b(I^2[k-1] + (d + 2c - 1)I^2[k-2])$$
$$= 2T_{avg}[k] + (-4 + 2d + 2c + 2a)T_{avg}[k-1]$$
$$+ (2 - 2d - 2c - 2a + 2ad)T_{avg}[k-2] - 2adT_f[k-2]$$

The dependent variable may then be whitened by applying the following filter to remove correlation on noise that exists in $T_{avg}$:

$$H[z^{-1}] = \frac{1}{1 + (-2 + d + c + a)z^{-1} + (1 - d - c - a + ad)z^{-2}}$$

After which NLMS may be used to identify b.

The output equation that describes the relationship between $T_{avg}$ and model states (e.g., $T_{avg} = 0.5T_s + 0.5T_c$) can be determined in various manners. For example, the relationship may be determined from detailed 3D finite element battery thermal model simulations. Alternatively, the relationship may be determined using extensive battery measurements obtained using a large number of thermal sensors on the surface of the battery and building a temperature map from the measurements. In addition to surface sensors, thermal sensors may be placed inside the body of the battery to directly measure core temperature, which may then be correlated with surface and impedance based average temperature. For example, the output equation may be described as a general weighted average:

$$T_{avg} = \alpha T_c + \beta T_s, \qquad \alpha + \beta = 1$$

or alternatively it could be described as a non-linear relationship:

$$T_{avg} = h(T_c, T_s)$$

where $h = h(\cdot)$ is a real-valued function, such as a multivariate polynomial.

If the output equation is linear, then a simple estimator, such as an ordinary KF, may be used to track the internal battery temperature. If the output equation is non-linear, a more complex estimator, such an extended KF, a particle filter, etc.) may be used.

*Example Techniques for Accommodating Different Sensor Measurement Rates*

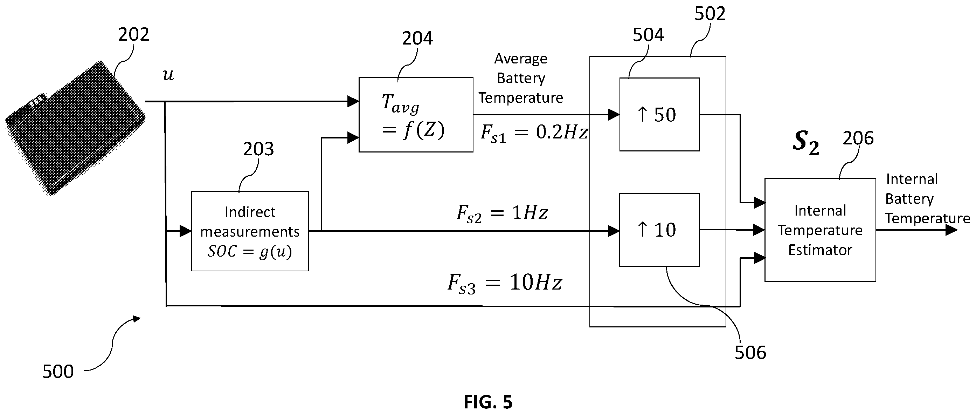

Different sensors in the system may, in general, provide measurements at different sample rates. For example, cell voltage and current measurements might be provided at 10-100 samples/second, while impedance measurements are available at less than 1 sample per second. One way of dealing with this issue is to preprocess all measurement signals before they are fed into the battery temperature estimator. The preprocessing operation may, for example, include up- or down-sampling operations in order to bring all measurement signals to the same sample rate. FIG. 5 illustrates a block diagram of a system 500 for implementing technique to deal with different sensor measurement rates.

As shown in FIG. 5, the system 500 is identical in all material respects to the system 200 with the exception of the addition of a preprocessing module 502. In the example illustrated in FIG. 5, the frequency (or sample rate) of the average battery temperature signal ($T_{avg}$) is 0.2Hz, the frequency of the indirect measurement signal (g(u)) is 1Hz, and the frequency of the observable measurement signal (u) is 10Hz. The signals are input to the preprocessing module 502 which up-samples $T_{avg}$ by 50 at submodule 504 and up-samples the g(u) by 10 at submodule 506 such that the frequencies of all three signals are the same when input to the core temperature estimator 206.

It will be recognized that the estimator itself may also trigger measurements, which may occur at a time or rate that is misaligned with the other measurements without negatively impacting processing, as such measurements may be handled as described hereinabove.

Alternatively, different measurement rates may be handled by adjusting the estimation algorithm in the internal battery temperature estimator. For example, after estimating parameter of the lumped model, the state space model may be constructed as:

$$\begin{bmatrix} T_c[k+1] \\ T_s[k+1] \end{bmatrix} = \begin{bmatrix} 1 - a & a \\ c & 1 - d - c \end{bmatrix} \begin{bmatrix} T_c[k] \\ T_s[k] \end{bmatrix} + \begin{bmatrix} b & 0 \\ 0 & d \end{bmatrix} \begin{bmatrix} I^2[k] \\ T_f[k] \end{bmatrix}$$

$$T_{avg}[k] = \begin{bmatrix} 0.5 & 0.5 \end{bmatrix} \begin{bmatrix} T_c[k] \\ T_s[k] \end{bmatrix}$$

*Expanded Thermal Model Example*

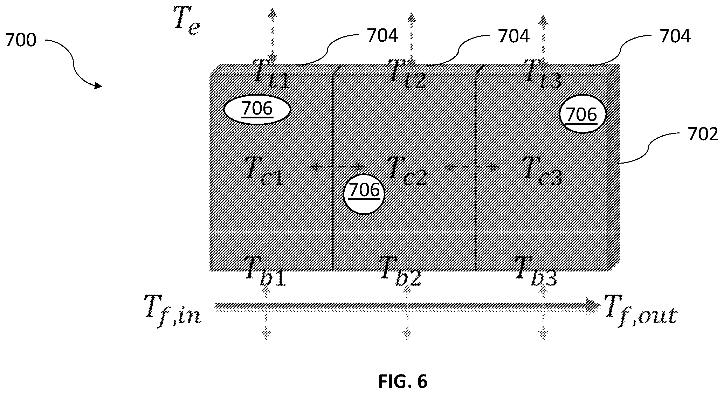

A typical EV cell is typically much bigger than the cylindrical pouch cell 402 shown in FIG. 4 and experiences non-uniform temperature distributions across its body. The coarsely lumped temperatures of the core and surface described above do not track such gradients. Accordingly, the model 400 illustrated in FIG. 4 may be expanded to a model 700, as shown in FIG. 6, by dividing a battery 702 into multiple (e.g., three (3)) segments 704 each with lumped core $T_c$, top Tt, and bottom temperatures $T_b$, as shown in FIG. 6. The expanded thermal model represented in FIG. 6 takes into account spatial non-homogeneity of thermal properties. For example, in physically large batteries, such as EV batteries, there may be multiple hot spots 706, leading to multiple internal or core temperatures of interest. The expanded thermal model allows for tracking/estimation of each of these hotspots, leading to a system that can track/estimate multiple internal or core temperatures. For purposes of illustration herein, thin cells are used such that fluctuations across the thickness thereof may be ignored, although the model may be extended trivially to cells of any dimensions.

Referring again to FIG. 6, for the battery 702, the expanded lumped thermal model 700 may be defined by the following set of equations:

$$C_c \frac{dT_{c,i}(t)}{dt} = I^2(t)R_c - I(t)T_{c,i}(t)\frac{\Delta S}{nF} + \frac{T_{t,i}(t) - T_{c,i}(t)}{R_{c_1}} + \frac{T_{b,i}(t) - T_{c,i}(t)}{R_{c_1}} + \frac{T_{c,N_i}(t) - T_{c,i}(t)}{R_{c_0}}, \quad (6)$$

$$C_s \frac{dT_{t,i}}{dt} = \frac{T_e(t) - T_{t,i}(t)}{R_{s_0}} - \frac{T_{t,i}(t) - T_{c,i}(t)}{R_{c_1}}, \quad (7)$$

$$C_s \frac{dT_{b,i}}{dt} = \frac{T_{f,i}(t) - T_{b,i}(t)}{R_{s_1}} - \frac{T_{b,i}(t) - T_{c,i}(t)}{R_{c_1}}. \quad (8)$$

where i represents the segment of the battery in consideration, $T_c$, Tt, and $T_b$ represent the internal, top and bottom surface temperatures, respectively, and $T_f$ is the coolant fluid temperature. In equation (6), $T_{c,N_i}$ is the average internal temperature of the segments that are neighboring to segment i of the cell. In equations (6)-(8), $R_{c1}$ and $R_{c0}$ are the thermal resistances between the body core and the surface and between adjacent body cores of the cell, respectively. Similarly, $R_{s0}$ and $R_{s1}$ are the thermal resistances between the top surface and the environment and between the bottom surface and the coolant fluid, respectively. Additionally, $T_{f,i}$ represents the average temperature of the coolant fluid as adjacent to segment i. Given the inlet $T_{f,in}$ and outlet $T_{f,out}$ temperatures of the coolant, the values of the average coolant fluid temperature could be interpolated or estimated by expanding the lumped model to incorporate the coolant temperatures. Alternatively, in the absence of a coolant fluid, the temperature may be correspondingly altered to the ambient temperature $T_e$.

The discretized state space model for the battery 702 illustrated in FIG. 6 may be analogously defined as described in detail above with reference to the battery 402 (FIG. 4).

*Example Temperature Tracking Algorithms*

The thermal models described above indicate the feasibility of developing tracking algorithms that estimate the battery internal temperatures. A regression algorithm may be used to estimate the average battery temperature from EIS measurements such that:

$$T_{avg}(t) \approx \hat{T}_{avg}(t) = f_{reg}(\mathbf{Z}(t)). \quad (9)$$

The average temperature of the battery may be derived as a convex combination of the internal and surface temperatures of the cell. For instance, with respect to the cylindrical pouch cells (such as shown in

$$T_{avg}(t) = \alpha T_c(t) + (1 - \alpha)T_s(t) \quad (10)$$

Analogously, for the larger cells, if the expanded thermal model is composed of n segments, the average temperature estimated by the regression algorithm may be approximated as:

$$T_{avg}(t) = \frac{1}{n}\sum_{i \le n} \alpha T_{c,i}(t) + \beta_t T_{t,i}(t) + \beta_b T_{b,i}(t), \quad (11)$$

where $\alpha + \beta_t + \beta_b = 1$.

Given the observations from the estimates of the average temperature, one possible way to track the internal temperature would be to pair the thermal model described above with the corresponding measurement model represented by equations (10) and (11) and implement a KF to track the state estimates.

*Example Undersampled Kalman Filter for use in Temperature Tracking*

Whereas a KF may be effective in tracking the battery temperatures given the linear nature of the thermal model described hereinabove, in the present case, battery temperatures are to be monitored over relatively high sampling frequencies (on the order of 10 Hz) while the EIS measurements are made roughly once every few seconds; as a result, a conventional KF is not viable for estimating battery temperatures.

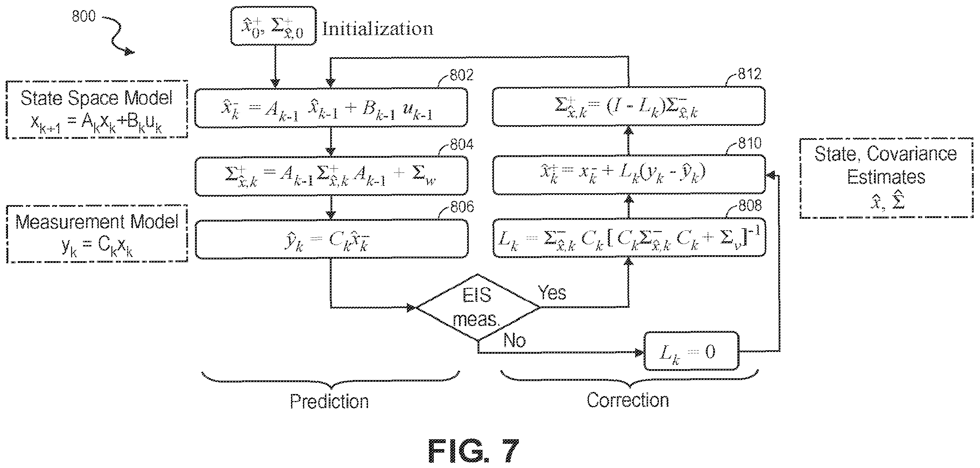

In accordance with features of embodiments described herein, an undersampled KF, as shown in FIG. 7, is defined that optimally tracks the states given the undersampled observations. It should be noted that the undersampled KF (FIG. 7) functions the same as a simple KF when new EIS measurements are made; however, in the absence of new EIS measurements, the undersampled KF updates the estimates according to the state space model. To elaborate, FIG. 7 is a flow diagram 800 illustrating operation of an undersampled KF for use in embodiments described herein. As shown in FIG. 7, in step 802, the state estimated is updated whenever the measurement u is received. Since u is received much faster than the estimate of average temperature y, the system runs the prediction loop comprising blocks 802, 804, and 806 whenever the average temperature estimates are not available, and effectively skips making corrections to the state estimates. Here, in block 804 the covariance matrix in the estimate of the states is updated and in 806 the expected estimate of y, given the updated system state is evaluated. The correction steps are used when estimates of y are made available, i.e., when average temperature estimates are made in this application. When y is available, the correction step first computes a Kalman gain matrix L as shown in 808 which caters to the weight to be accorded to the correction step. The state correction based on the observed estimate y in comparison to that computed in 806 is performed in 810. Finally, the state covariance estimate is also corrected accordingly in 812. The undersampled KF enables the thermal model to be leveraged to track the internal temperatures of the battery at the desired sampling frequency using undersampled or non-uniformly sampled measurements of the average temperature.

*Example Techniques for Calibration and Recalibration of Thermal Model Parameters*

As noted above, the discretized lumped model for a cylindrical cell is given by equation (3). Matrices A, B, are characterized by the following parameters:

$$a = \frac{1}{C_c R_c}, \quad b = \frac{R_s}{C_c}, \quad c = \frac{1}{C_s R_c}, \quad d = \frac{1}{C_s R_s}, \quad e = \frac{T_c \Delta S}{nF}. \tag{12}$$

All these parameters, except for e are non-negative. The parameter e is dependent on the sign of the change of entropy parameter $\Delta S$; the sign of e will be discussed in greater detail hereinbelow. For the present discussion, it will be assumed that all parameters are non-negative.

The system identification may be done using multiple possible approaches. One approach is to directly use the core and surface temperature measurements made during calibration experiments run on the cells. Given access to these temperatures, the parameters can be inferred by using a non-negative linear least squares solver on the following set of equations:

$$\frac{T_c[n+1] - T_c[n]}{\Delta t} = a(T_s[n] - T_c[n]) + bI^2(t) - eI(t),$$

$$\frac{T_s[n+1] - T_s[n]}{\Delta t} = c(T_c[n] - T_s[n]) + d(T_a[n] - T_s[n]).$$

In cases in which it is possible to track the surface temperature and estimate the average temperature of a cell but in which there is no access to the core temperature of the cell, the average temperature may be used to obtain the core temperature in the above equations. Model parameters can then be extracted using the non-negative linear least squares method. This may be accomplished by using equation (10) to obtain the core temperature from the average and surface temperatures. Thus, one of these approaches provides an estimate of the parameters governing the lumped thermal model for the small cells.

The calibration mechanism described above provides an initial estimate for the parameters of the lumped thermal model; however, parameters such as the internal resistance of the cell $R_e$ and entropy change $\Delta S$ vary with and/or are dependent on battery state. In particular, the internal resistance of a cell varies with the core temperature $T_c$, the state-of-charge (SOC), and the state-of-health (SOH) of the cell. This in turn implies that the parameter b in equation (12) varies with cell usage over time. Similarly, the entropy change also varies with the cell SOC and SOH; therefore, the parameter e in equation (12) varies with usage. This emphasizes the need for a mechanism to update these parameters as they vary with the cell usage. This situation may be addressed using various approaches, such as online recalibration, parametric modeling, lookup tables, and a dual-tracking algorithm.

In the online recalibration approach, if the cell is equipped with a surface thermocouple that provides access to the ground truth measurement of the surface temperature, we can define an online recalibration algorithm to calculate the parameters b, e over cell usage. This may be done by making using of equation (1) by approximating the core temperature using the average temperature and the measurement of the thermocouple.

In the parametric modeling approach, the variation of the cell parameters may be characterized using parametric models. For instance, the internal resistance of the cell can be characterized using the Arrhenius model. Analogously, its variation with SOC may be estimated using a polynomial model. Thus, the parameter may be modeled as:

$$R_c(T_c, SOC) = f_{\text{poly}}(SOC)\exp\left\{\frac{T_0}{T_c - T_0}\right\} \tag{13}$$

The same may also be done for the entropy change; that is, it may be modeled using a polynomial function of the SOC. These parametric models may be developed by subjecting the cells to calibration experiments at various temperatures to estimate the hyperparameters defining the parametric models.

In the lookup table approach, if the cell parameters do not vary significantly over the cell states, a lookup table comprising the estimates of the parameters for different ranges of SOC and $T_c$ may be employed. In the dual-tracking algorithms approach, more complex tracking algorithms may be developed that serve a dual purpose of tracking the cell temperatures and parameters over usage. This approach may be used if a state, or a function of one of the states, is measurable (e.g., if the surface temperature is measurable using a thermocouple). One such algorithm is a Dual Kalman Filter. Other similar approaches may be developed to track the parameters along with the cell temperatures.

*Example Techniques for Adapting Estimator Measurement Error Covariance Matrix*

As described above, a temperature regression equation converts EIS measurements to temperature estimates, which may then be fed into a KF state estimator for temperature tracking. In this scheme, the temperature estimates are input "measurements" to the KF. The KF combines these "measurements" with a temperature estimate from its process model. This fusion of estimates requires a model of error statistics of the temperature regression equation. In particular, the bias of the regression equation $\mu_v$ must be modeled and subtracted out. The KF measurement error covariance matrix $\Sigma_v$ is then simply the error covariance matrix of the regression equation. Both the bias and covariance of the regression equation may be computed empirically through applying the regression equation to static EIS/temperature battery data.

It will be noted that the error statistics of the regression equation are a strong function of battery state variables, specifically SOC, SOH, and temperature. In accordance with features of embodiments described herein, $\mu_v$ and $\Sigma_v$ are adapted based on the current state estimate of SOC, SOH, and/or temperature (or whichever estimates are available). The $\mu_v$ and $\Sigma_v$ error statistics may be empirically computed for specific ranges of state variables. For example, the static battery data on which the regression equation is tested may be binned into ranges of SOC, SOH, and temperature, and the error statistics may be computed for each bin separately. These statistics may be stored in a lookup table and applied online based on the current state estimates.

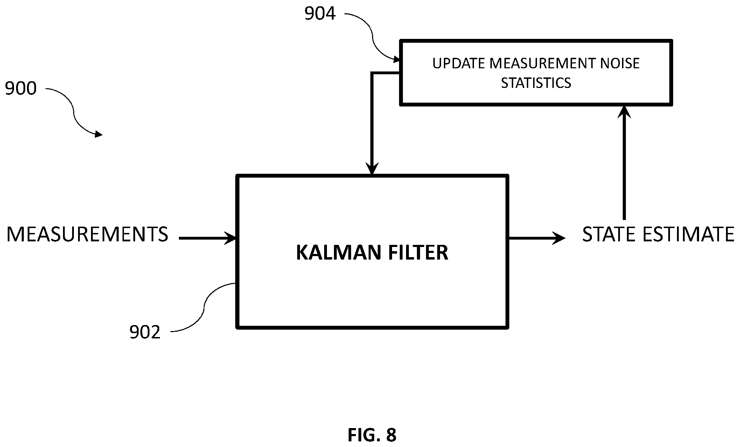

In one embodiment of the estimator, the measurement error noise statistics may be adapted based on the current estimate of battery state. FIG. 8 is a flow diagram 900 of a technique for adapting the measurement error covariance matrix for the estimator in accordance with features of embodiments described herein. As shown in FIG. 8, battery average temperature "measurements" input to an estimator 902 (implemented as a KF) may actually be the output of an EIS-based temperature regression equation. Based on the current estimated state, the measurement error covariance matrix of the estimator 902 may be adapted, or updated 904, based on the state estimate output from the estimator 902. In accordance with features of embodiments described herein, the temperature regression equation's error bias and covariance matrix may be computed for different combinations of battery state by using existing EIS and temperature datasets, binning the data sets by battery state (using a quantized grid) and then empirically computing the error statistics for each bin.

*Example Techniques for Entropic Heat Modeling*

In one embodiment of the temperature tracking model, an entropy heating term ( $\frac{-T\Delta S}{nF} I$ ,) in addition to a resistive heating term (I$^2$R), may be included in the equation. The entropy heating term represents the heat generated by the entropy change of the battery's electrochemical reaction. The entropy heating is proportional to the battery's terminal current I, in contrast to sensitive heating, which is proportional to I$^2$.

Embodiments described herein enable implementation of an internal battery temperature tracker that does state updating based on average temperature estimate calculated from battery impedance measurements at multiple frequencies (and, optionally, other direct measurements such as terminal voltage, or indirect measurements such as cell capacity or state-of-charge).

Embodiments described herein enable battery thermal model parameters to be learned from the indirect measurement of average internal battery temperature without the need for measuring internal or surface temperature. This reduces complexity of the model parameter learning procedure, both offline and *in situ.* It also reduces need for expensive surface-mounted thermal sensors. Embodiments described herein further may be used to estimate temperature of individual batteries/cells in multi-cell battery packs. Adaptive model parameter learning and calibration is possible due to the availability of impedance measurement from each individual battery in the pack. This feature may be enabled by an extension (or expansion) of the thermal model as described above.

Additionally, embodiments described herein may be less sensitive to changes in battery parameters caused by aging due to model parameters being calibrated from terminal impedance measurements and not just surface thermocouples (since terminal impedance has high correlation with true physical battery states). Moreover, the thermal model described herein remains linear in coefficients and allows simple least squares method to be used for model parameter learning. Linearity of the model also implies simpler tracking algorithm.

Embodiments described herein allow for use of measurements with possibly different sample rates and time stamps (either sampled at different times or possibly event-triggered samples) through use of an undersampled KF as described above. Embodiments may further provide (1) the ability to track multiple internal and surface temperatures across individual segments of the cell to obtain a finer resolution of the internal cell temperature of the cell in use; (2) the ability to update thermal model parameters to track the variations of the cell properties with the cell usage; (3) the ability to use the measurement error covariance matrix to improve the performance of the tracking algorithm across cell states by tuning it accordingly to the performance of the regression algorithm; and (4) the ability to incorporate the heat generated as a result of the change in entropy in the cell through use of lumped thermal models.

*Example Computer System for Implementing Internal Battery Temperature Estimation*

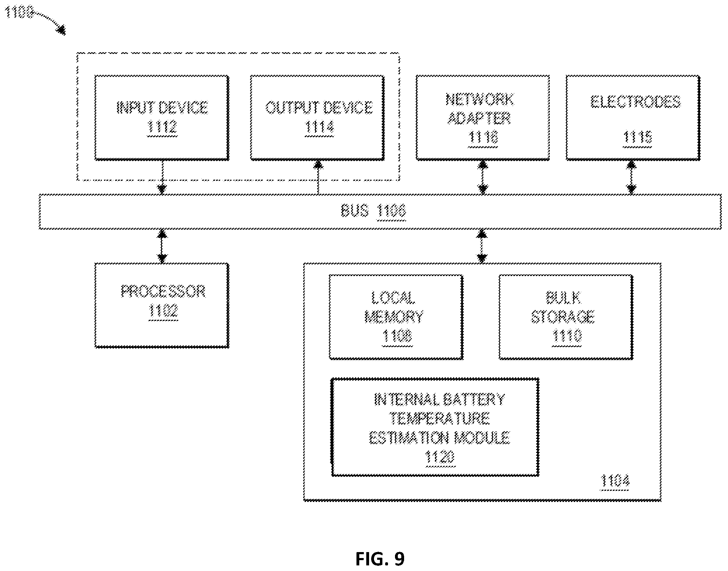

FIG. 9 is a block diagram illustrating an example system 1100 that may be configured to implement at least portions of techniques for internal battery temperature estimation using impedance measurements in accordance with features of embodiments described herein, and more particularly as shown in the FIGURES described hereinabove. As shown in FIG. 9, the system 1100 may include at least one processor 1102, e.g., a hardware processor 1102, coupled to memory elements 1104 through a system bus 1106. As such, the system may store program code and/or data within memory elements 1104. Further, the processor 1102 may execute the program code accessed from the memory elements 1104 via a system bus 1106. In one aspect, the system may be implemented as a computer that is suitable for storing and/or executing program code. It should be appreciated, however, that the system 1100 may be implemented in the form of any system including a processor and a memory that is capable of performing the functions described in this disclosure.

In some embodiments, the processor 1102 can execute software or an algorithm to perform the activities as discussed in this specification; in particular, activities related to internal battery temperature estimation using impedance measurements in accordance with features of embodiments described herein. The processor 1102 may include any combination of hardware, software, or firmware providing programmable logic, including by way of non-limiting example a microprocessor, a DSP, a field-programmable gate array (FPGA), a programmable logic array (PLA), an integrated circuit (IC), an application specific IC (ASIC), or a virtual machine processor. The processor 1102 may be communicatively coupled to the memory element 1104, for example in a direct-memory access (DMA) configuration, so that the processor 1102 may read from or write to the memory elements 1104.

In general, the memory elements 1104 may include any suitable volatile or non-volatile memory technology, including double data rate (DDR) random access memory (RAM), synchronous RAM (SRAM), dynamic RAM (DRAM), flash, read-only memory (ROM), optical media, virtual memory regions, magnetic or tape memory, or any other suitable technology. Unless specified otherwise, any of the memory elements discussed herein should be construed as being encompassed within the broad term "memory." The information being measured, processed, tracked, or sent to or from any of the components of the system 1100 could be provided in any database, register, control list, cache, or storage structure, all of which can be referenced at any suitable timeframe. Any such storage options may be included within the broad term "memory" as used herein. Similarly, any of the potential processing elements, modules, and machines described herein should be construed as being encompassed within the broad term "processor." Each of the elements shown in the present figures may also include suitable interfaces for receiving, transmitting, and/or otherwise communicating data or information in a network environment so that they can communicate with, for example, a system having hardware similar or identical to another one of these elements.

In certain example implementations, mechanisms for implementing internal battery temperature estimation using impedance measurements as outlined herein may be implemented by logic encoded in one or more tangible media, which may be inclusive of non-transitory media, e.g., embedded logic provided in an ASIC, in DSP instructions, software (potentially inclusive of object code and source code) to be executed by a processor, or other similar machine, etc. In some of these instances, memory elements, such as e.g., the memory elements 1104 shown in FIG. 9 can store data or information used for the operations described herein. This includes the memory elements being able to store software, logic, code, or processor instructions that are executed to carry out the activities described herein. A processor can execute any type of instructions associated with the data or information to achieve the operations detailed herein. In one example, the processors, such as e.g., the processor 1102 shown in FIG. 9, could transform an element or an article (e.g., data) from one state or thing to another state or thing. In another example, the activities outlined herein may be implemented with fixed logic or programmable logic (e.g., software/computer instructions executed by a processor) and the elements identified herein could be some type of a programmable processor, programmable digital logic (e.g., an FPGA, a DSP, an erasable programmable read-only memory (EPROM), an electrically erasable programmable read-only memory (EEPROM)) or an ASIC that includes digital logic, software, code, electronic instructions, or any suitable combination thereof.

The memory elements 1104 may include one or more physical memory devices such as, for example, local memory 1108 and one or more bulk storage devices 1110. The local memory may refer to RAM or other non-persistent memory device(s) generally used during actual execution of the program code. A bulk storage device may be implemented as a hard drive or other persistent data storage device. The processing system 1100 may also include one or more cache memories (not shown) that provide temporary storage of at least some program code in order to reduce the number of times program code must be retrieved from the bulk storage device 1110 during execution.

As shown in FIG. 9, the memory elements 1104 may store an internal battery temperature estimation module 1120. In various embodiments, the module 1120 may be stored in the local memory 1108, the one or more bulk storage devices 1110, or apart from the local memory and the bulk storage devices. It should be appreciated that the system 1100 may further execute an operating system (not shown in FIG. 9) that can facilitate execution of the module 1120. The module 1120, being implemented in the form of executable program code and/or data, can be read from, written to, and/or executed by the system 1100, e.g.., by the processor 1102. Responsive to reading from, writing to, and/or executing the module 1120, the system 1100 may be configured to perform one or more operations or method steps described herein.

Input/output (I/O) devices depicted as an input device 1112 and an output device 1114, optionally, may be coupled to the system. Examples of input devices may include, but are not limited to, a keyboard, a pointing device such as a mouse, or the like. Examples of output devices may include, but are not limited to, a monitor or a display, speakers, or the like. In some implementations, the system may include a device driver (not shown) for the output device 1114. Input and/or output devices 1112, 1114 may be coupled to the system 1100 either directly or through intervening I/O controllers. Additionally, sensors 1115, may be coupled to the system 1100 either directly or through intervening controllers and/or drivers.

In an embodiment, the input and the output devices may be implemented as a combined input/output device (illustrated in FIG. 9 with a dashed line surrounding the input device 1112 and the output device 1114). An example of such a combined device is a touch sensitive display, also sometimes referred to as a "touch screen display" or simply "touch screen." In such an embodiment, input to the device may be provided by a movement of a physical object, such as e.g., a stylus or a finger of a user, on or near the touch screen display.

A network adapter 1116 may also, optionally, be coupled to the system 1100 to enable it to become coupled to other systems, computer systems, remote network devices, and/or remote storage devices through intervening private or public networks. The network adapter may comprise a data receiver for receiving data that is transmitted by said systems, devices and/or networks to the system 1100, and a data transmitter for transmitting data from the system 1100 to said systems, devices and/or networks. Modems, cable modems, and Ethernet cards are examples of different types of network adapter that may be used with the system 1100.

_Select Examples_

Example 1 is a system for estimating an internal temperature of a battery, the system comprising a first circuit for receiving a system input signal comprising a measurement of at least one observable quantity associated with the battery and outputting an average battery temperature signal based on the system input signal; and an estimator for receiving the system input signal and the average battery temperature signal and estimating a current state of the battery based on the received signals, wherein the estimator comprises a thermal model of the battery comprising a plurality of model parameters.

Example 2 provides the system of example 1, wherein the current state of the battery comprises at least one internal temperature of the battery.

Example 3 provides the system of any of examples 1-2, wherein the first circuit further receives a second input signal, the second input signal comprising an indirect measurement of the observable quantity, the first circuit outputting the average battery temperature based on the system input signal and the second input signal.

Example 4 provides the system of example 3, wherein the estimator further receives the second input signal, the estimator estimating the core temperature of the battery based on the system input signal, the average battery temperature signal, and the second input signal.

Example 5 provides the system of example 2, wherein the indirect measurement comprises at least one of a state-of-charge (SOC) of the battery, a state of health (SOH) of the battery, and a cell capacity of the battery.

Example 6 provides the system of any of examples 1-2, wherein the thermal model comprises an expanded thermal model for modeling each of a plurality of segments of the battery and thermal interactions between the battery segments, and wherein the current state of the battery comprises an internal temperature of each of the plurality of segments.

Example 7 provides the system of any of examples 1-2, wherein the observable quantity comprises at least one of a voltage, a current, an impedance, a surface temperature, a state-of-charge (SOC), and a temperature of battery coolant.

Example 8 provides the system of any of examples 1-2, wherein the estimator comprises a Kalman Filter.

Example 9 provides the system of example 8, wherein the Kalman Filter is an undersampled Kalman Filter.

Example 10 provides the system of example 8, wherein measurement noise error statistics for the Kalman Filter are updated based on a current estimate of the battery state.

Example 11 provides the system of any of examples 1-2, wherein the estimator includes a preprocessing module for changing a sampling rate of at least one of the received signals to match a sampling rate of at least one other one of the received signals.

Example 12 provides the system of example 11, wherein the changing the sampling rate of the at least one of the received signals comprises up-sampling the at least one of the received signals.

Example 13 provides the system of example 11, wherein the changing the sampling rate of the at least one of the received signals comprises down-sampling the at least one of the received signals.

Example 14 provides the system of any of examples 1-2, wherein the model parameters are learned from an indirect measurement of average internal battery temperature.

Example 15 provides the system of any of examples 1-2, wherein the model parameters are calibrated from terminal impedance measurements of the battery.

Example 16 provides the system of any of examples 1-2, wherein the thermal model is defined by a linear equation.

Example 17 provides the system of any of examples 1-2, wherein the model parameters are updated using at least one of a lookup table, a parametric model, a Dual Extended Kalman Filter, and an online comparison process.

Example 18 provides the system of any of examples 1-2, wherein an equation comprising the thermal battery model includes a resistive heating term and an entropy heating term.

Example 19 provides the system of example 18, wherein the resistive heating term is proportional to a battery current squared and the entropy heating term is proportional to the battery current.

Example 20 provides a system for estimating an internal temperature of a battery, the system comprising a first circuit for receiving a first input signal comprising a measurement of at least one observable quantity associated with the battery and a second input signal comprising an indirect measurement of the observable quantity and outputting an average battery temperature signal based on the system input signal; and an estimator for receiving the first and second input signals and the average battery temperature signal output and estimating the internal temperature of the battery based on the received signals, the estimator outputting a signal comprising the estimated internal temperature, wherein the estimator comprises a thermal model of the battery comprising a plurality of model parameters.

Example 21 provides the system of example 20, wherein the thermal model comprises an expanded thermal model that models each of a plurality of segments of the battery and that models thermal interactions between the battery segments, and wherein the current state of the battery comprises an internal temperature of each of the plurality of segments.

Example 22 provides the system of any of examples 20-21, wherein the observable quantity comprises at least one of a voltage, a current, an impedance, a surface temperature, a state-of-charge (SOC), and a temperature of battery coolant.

Example 23 provides the system of any of examples 20-21, wherein the indirect measurement comprises at least one of a state-of-charge (SOC) of the battery, a state of health (SOH) of the battery, and a cell capacity of the battery.

Example 24 provides the system of any of examples 20-21, wherein the estimator comprises a Kalman Filter.

Example 25 provides the system of example 24, wherein measurement noise error statistics for the Kalman Filter are updated on a current estimate of the internal temperature output from the estimator.

Example 26 provides the system of any of examples 20-21, wherein the Kalman Filter is an undersampled Kalman Filter.

Example 27 provides the system of any of examples 20-21, wherein the estimator includes a preprocessing module for adjusting a sampling rate of a first one of the received signals to match a sampling rate of a second one of the received signals.

Example 28 provides the system of example 27, wherein the adjusting the sampling rate of the first one of the received signals comprises at least one of up-sampling the first one of the received signals and down-sampling the first one of the received signals.

Example 29 provides the system of any of examples 20-21, wherein the model parameters are learned from an indirect measurement of average internal battery temperature.

Example 30 provides the system of any of examples 20-21, wherein the model parameters are calibrated using electrochemical impedance spectroscopy (EIS) terminal impedance measurements of the battery.

Example 31 provides the system of any of examples 20-21, wherein the model parameters are updated using at least one of a lookup table, a parametric model, a Dual Extended Kalman Filter, and an online comparison process.

Example 32 provides the system of any of examples 20-21, wherein a linear equation comprising the thermal battery model includes a resistive heating term and an entropy heating term.

Example 33 provides the system of example 32, wherein the resistive heating term is proportional to a battery current squared and the entropy heating term is proportional to the battery current.

Example 34 provides a method of estimating an internal temperature of a battery, the method comprising determining an average battery temperature based on a system input signal comprising a measurement of at least one observable quantity associated with the battery; and estimating a current state of the battery based on the system input signal and the average battery temperature signal, wherein the estimating is performed using a thermal model comprising a plurality of model parameters, wherein the current state of the battery comprises the temperature of the battery.

Example 35 provides the method of example 34, wherein the generating the average battery temperature is further based on a second input signal comprising an indirect measurement of the observable quantity.

Example 36 provides the method of example 35, wherein the estimating the current state of the battery is further based on the second input signal.

Example 37 provides the method of example 35, wherein the indirect measurement comprises at least one of a state-of-charge (SOC) of the battery, a state of health (SOH) of the battery, and a cell capacity of the battery.

Example 38 provides the method of any of examples claims 34-37, wherein the thermal model comprises an expanded thermal model, the expanded thermal model modeling each of a plurality of segments of the battery and thermal interactions between the battery segments.

Example 39 provides the method of any of examples 34-37, wherein the observable quantity comprises at least one of a voltage, a current, an impedance, a surface temperature, a state-of-charge (SOC), and a temperature of battery coolant.

Example 40 provides the method of any of examples 34-37, wherein the estimating is performed using a Kalman Filter.

Example 41 provides the method of any of examples 34-37, further comprising updating measurement noise error statistics for the Kalman Filter based on a current estimate of the battery state.

Example 42 provides the method of any of examples 34-37, wherein the estimating is performed using an undersampled Kalman Filter.

Example 43 provides the method of any of examples 34-37, wherein the estimating further comprises changing a sampling rate of at least one of the received signals to match a sampling rate of at least one other one of the received signals.

Example 44 provides the method of example 43, wherein the changing the sampling rate of the at least one of the received signals comprises up-sampling the at least one of the received signals.

Example 45 provides the method of example 43, wherein the changing the sampling rate of the at least one of the received signals comprises down-sampling the at least one of the received signals.

Example 46 provides the method of any of examples 34-37, further comprising learning the model parameters from an indirect measurement of average internal battery temperature.

Example 47 provides the method of any of examples 34-37, further comprising calibrating the model parameters from terminal impedance measurements of the battery.

Example 48 provides the method of any of examples 34-37, wherein the thermal model is defined by a linear equation comprising the thermal battery model includes a resistive heating term and an entropy heating term.

Example 49 provides the method of example 48, wherein the resistive heating term is proportional to a battery current squared and the entropy heating term is proportional to the battery current.

Example 50 provides the method of any of examples 34-37, further comprising updating the model parameters using at least one of a lookup table, a parametric model, a Dual Extended Kalman Filter, and an online comparison process.

*Conclusion*

It should be noted that all of the specifications, dimensions, and relationships outlined herein (e.g., the number of elements, operations, steps, etc.) have only been offered for purposes of example and teaching only. Such information may be varied considerably without departing from the spirit of the present disclosure, or the scope of the appended claims. The specifications apply only to one non-limiting example and, accordingly, they should be construed as such. In the foregoing description, exemplary embodiments have been described with reference to particular component arrangements. Various modifications and changes may be made to such embodiments without departing from the scope of the appended claims. The description and drawings are, accordingly, to be regarded in an illustrative rather than in a restrictive sense.

Note that with the numerous examples provided herein, interaction may be described in terms of two, three, four, or more electrical components. However, this has been done for purposes of clarity and example only. It should be appreciated that the system may be consolidated in any suitable manner. Along similar design alternatives, any of the illustrated components, modules, and elements of the FIGURES may be combined in various possible configurations, all of which are clearly within the broad scope of this specification. In certain cases, it may be easier to describe one or more of the functionalities of a given set of flows by only referencing a limited number of electrical elements. It should be appreciated that the electrical circuits of the FIGURES and its teachings are readily scalable and may accommodate a large number of components, as well as more complicated/sophisticated arrangements and configurations. Accordingly, the examples provided should not limit the scope or inhibit the broad teachings of the electrical circuits as potentially applied to myriad other architectures.

It should also be noted that in this specification, references to various features (e.g., elements, structures, modules, components, steps, operations, characteristics, etc.) included in "one embodiment", "exemplary embodiment", "an embodiment", "another embodiment", "some embodiments", "various embodiments", "other embodiments", "alternative embodiment", and the like are intended to mean that any such features are included in one or more embodiments of the present disclosure, but may or may not necessarily be combined in the same embodiments.

It should also be noted that the functions related to circuit architectures illustrate only some of the possible circuit architecture functions that may be executed by, or within, systems illustrated in the FIGURES. Some of these operations may be deleted or removed where appropriate, or these operations may be modified or changed considerably without departing from the scope of the present disclosure. In addition, the timing of these operations may be altered considerably. The preceding operational flows have been offered for purposes of example and discussion. Substantial flexibility is provided by embodiments described herein in that any suitable arrangements, chronologies, configurations, and timing mechanisms maybe provided without departing from the teachings of the present disclosure.

Numerous other changes, substitutions, variations, alterations, and modifications may be ascertained to one skilled in the art and it is intended that the present disclosure encompass all such changes, substitutions, variations, alterations, and modifications as falling within the scope of the appended claims.

Note that all optional features of the device and system described above may also be implemented with respect to the method or process described herein and specifics in the examples may be used anywhere in one or more embodiments.

The "means for" in these instances (above) may include (but is not limited to) using any suitable component discussed herein, along with any suitable software, circuitry, hub, computer code, logic, algorithms, hardware, controller, interface, link, bus, communication pathway, etc.

Note that with the example provided above, as well as numerous other examples provided herein, interaction may be described in terms of two, three, or four network elements. However, this has been done for purposes of clarity and example only. In certain cases, it may be easier to describe one or more of the functionalities of a given set of flows by only referencing a limited number of network elements. It should be appreciated that topologies illustrated in and described with reference to the accompanying FIGURES (and their teachings) are readily scalable and may accommodate a large number of components, as well as more complicated/sophisticated arrangements and configurations. Accordingly, the examples provided should not limit the scope or inhibit the broad teachings of the illustrated topologies as potentially applied to myriad other architectures.

It is also important to note that the steps in the preceding flow diagrams illustrate only some of the possible signaling scenarios and patterns that may be executed by, or within, communication systems shown in the FIGURES. Some of these steps may be deleted or removed where appropriate, or these steps may be modified or changed considerably without departing from the scope of the present disclosure. In addition, a number of these operations have been described as being executed concurrently with, or in parallel to, one or more additional operations. However, the timing of these operations may be altered considerably. The preceding operational flows have been offered for purposes of example and discussion. Substantial flexibility is provided by communication systems shown in the FIGURES in that any suitable arrangements, chronologies, configurations, and timing mechanisms may be provided without departing from the teachings of the present disclosure.

Although the present disclosure has been described in detail with reference to particular arrangements and configurations, these example configurations and arrangements may be changed significantly without departing from the scope of the present disclosure. For example, although the present disclosure has been described with reference to particular communication exchanges, embodiments described herein may be applicable to other architectures.

Numerous other changes, substitutions, variations, alterations, and modifications may be ascertained to one skilled in the art and it is intended that the present disclosure encompass all such changes, substitutions, variations, alterations, and modifications as falling within the scope of the appended claims. In order to assist the United States Patent and Trademark Office (USPTO) and, additionally, any readers of any patent issued on this application in interpreting the claims appended hereto, Applicant wishes to note that the Applicant: (a) does not intend any of the appended claims to invoke paragraph six (6) of 35 U.S.C. section 142 as it exists on the date of the filing hereof unless the words "means for" or "step for" are specifically used in the particular claims; and (b) does not intend, by any statement in the specification, to limit this disclosure in any way that is not otherwise reflected in the appended claims.

## Claims

1. A system (100, 200) for estimating an internal temperature of a battery, the system comprising:

   a first circuit (104, 204) for receiving a system input signal (u) comprising a measurement of at least one observable quantity associated with the battery and outputting a regression-based estimate of an average battery temperature signal based on the system input signal, wherein the observable quantity comprises at least one of a voltage, a current, an impedance, a surface temperature, a state-of-charge, SOC, and a temperature of battery coolant; and
   an estimator (106, 206) for receiving the system input signal and the average battery temperature signal and estimating a current state of the battery based on the received signals,
   wherein the estimator comprises a thermal model of the battery comprising a plurality of model parameters, and
   wherein the current state of the battery comprises an internal temperature of the battery.

2. The system of claim 1, wherein the first circuit further receives a second input signal, the second input signal comprising an indirect measurement of the observable quantity, the first circuit outputting the average battery temperature based on the system input signal and the second input signal, wherein the indirect measurement comprises at least one of a state-of-charge, SOC, of the battery, a state of health, SOH, of the battery, and a cell capacity of the battery, and optionally wherein the estimator further receives the second input signal, the estimator estimating the internal temperature of the battery based on the system input signal, the average battery temperature signal, and the second input signal.

3. The system of claim 1, wherein the thermal model comprises an expanded thermal model for modeling each of a plurality of segments of the battery and thermal interactions between the battery segments, and wherein the current state of the battery comprises an internal temperature of each of the plurality of segments.

4. The system of any of claim 1, wherein the estimator comprises a Kalman Filter, optionally wherein the Kalman Filter is an undersampled Kalman Filter, or measurement noise error statistics for the Kalman Filter are updated based on a current estimate of the battery state.

5. The system of claim 1, wherein the estimator includes a preprocessing module for changing a sampling rate of at least one of the received signals to match a sampling rate of at least one other one of the received signals, optionally wherein the changing the sampling rate of the at least one of the received signals comprises up-sampling the at least one of the received signals, or the changing the sampling rate of the at least one of the received signals comprises down-sampling the at least one of the received signals.

6. The system of any of claim 1, wherein the model parameters:

   are learned from an indirect measurement of average internal battery temperature;
   are calibrated from terminal impedance measurements of the battery; or
   are updated using at least one of a lookup table, a parametric model, a Dual Extended Kalman Filter, and an online comparison process.

7. The system of claim 1, wherein the thermal model is defined by a linear equation.

8. The system of claim 1, wherein an equation comprising the thermal battery model includes a resistive heating term and an entropy heating term, optionally wherein the resistive heating term is proportional to a battery current squared and the entropy heating term is proportional to the battery current.

9. A method of estimating an internal temperature of a battery, the method comprising:

   determining an average battery temperature based on a system input signal comprising a measurement of at least one observable quantity associated with the battery, wherein the observable quantity comprises at least one of a voltage, a current, an impedance, a surface temperature, a state-of-charge, SOC, and a temperature of battery coolant; and
   estimating a current state of the battery based on the system input signal and the average battery temperature signal, wherein the estimating is performed using a thermal model comprising a plurality of model parameters, wherein the current state of the battery comprises an internal temperature of the battery.

10. The method of claim 9, wherein the generating the average battery temperature is further based on a second input signal comprising an indirect measurement of the observable quantity, optionally wherein the estimating the current state of the battery is further based on the second input signal, or the indirect measurement comprises at least one of a state-of-charge, SOC, of the battery, a state of health, SOH, of the battery, and a cell capacity of the battery.

11. The method of any of claims 9-10, wherein the thermal model comprises an expanded thermal model, the expanded thermal model modeling each of a plurality of segments of the battery and thermal interactions between the battery segments.

12. The method of any of claims 9-11, wherein the estimating is performed using a Kalman Filter, and optionally the method further comprises updating measurement noise error statistics for the Kalman Filter based on a current estimate of the battery state, or the estimating is performed using an undersampled Kalman Filter.

13. The method of any of claims 9-10, wherein the estimating further comprises changing a sampling rate of at least one of the received signals to match a sampling rate of at least one other one of the received signals, optionally wherein the changing the sampling rate of the at least one of the received signals comprises up-sampling the at least one of the received signals, or the changing the sampling rate of the at least one of the received signals comprises down-sampling the at least one of the received signals.

14. The method of any of claims 9-10, further comprising:

   learning the model parameters from an indirect measurement of average internal battery temperature;
   calibrating the model parameters from terminal impedance measurements of the battery; or
   updating the model parameters using at least one of a lookup table, a parametric model, a Dual Extended Kalman Filter, and an online comparison process.

15. The method of any of claims 9-10, wherein the thermal model is defined by a linear equation comprising the thermal battery model includes a resistive heating term and an entropy heating term, optionally wherein the resistive heating term is proportional to a battery current squared and the entropy heating term is proportional to the battery current.

**Patentansprüche**

1. System (100, 200)
   zum Schätzen einer internen Temperatur einer Batterie, wobei das System Folgendes umfasst:

   einen ersten Schaltkreis (104, 204) zum Empfangen eines Systemeingabesignals (u), umfassend eine Messung von mindestens
   einer beobachtbaren Größe, die mit der Batterie assoziiert ist, und Ausgeben einer auf Regression basierenden Schätzung eines durchschnittlichen Batterietemperatursignals basierend auf dem Systemeingabesignal, wobei die beobachtbare Größe mindestens eines aus einer Spannung, einem Strom, einer Impedanz, einer Oberflächentemperatur, einem Ladezustand, SOC, und einer Temperatur von Batteriekühlmittel umfasst; und einen Schätzer (106, 206)

zum Empfangen des Systemeingabesignals und des durchschnittlichen Batterietemperatursignals und Schätzen eines aktuellen Zustands der Batterie basierend auf den empfangenen Signalen, wobei der Schätzer ein thermisches Modell der Batterie umfasst, umfassend eine Vielzahl von Modellparametern, und wobei der aktuelle Zustand der Batterie eine interne Temperatur der Batterie umfasst.

2. System nach Anspruch 1, wobei der erste Schaltkreis weiter ein zweites Eingabesignal empfängt, wobei das zweite Eingabesignal eine indirekte Messung der beobachtbaren Größe umfasst, wobei der erste Schaltkreis die durchschnittliche Batterietemperatur basierend auf dem Systemeingabesignal und dem zweiten Eingabesignal ausgibt, wobei die indirekte Messung mindestens eines aus einem Ladezustand, SOC, der Batterie, einem Gesundheitszustand, SOH, der Batterie, und einer Zellkapazität der Batterie umfasst, und optional wobei der Schätzer weiter das zweite Eingabesignal empfängt, wobei der Schätzer die interne Temperatur der Batterie basierend auf dem Systemeingabesignal, dem durchschnittlichen Batterietemperatursignal und dem zweiten Eingabesignal schätzt.

3. System nach Anspruch 1, wobei das thermische Modell ein ausdehnbares thermisches Modell zum Modellieren jedes einer Vielzahl von Segmenten der Batterie und thermischer Interaktionen zwischen den Batteriesegmenten umfasst, und wobei der aktuelle Zustand der Batterie eine interne Temperatur jedes der Vielzahl von Segmenten umfasst.

4. System nach einem der Ansprüche 1, wobei der Schätzer einen Kalman-Filter umfasst, optional wobei der Kalman-Filter ein unterabgetasteter Kalman-Filter ist, oder die Messrauschfehlerstatistik für den Kalman-Filter basierend auf einer aktuellen Schätzung des Batteriezustands aktualisiert wird.

5. System nach Anspruch 1, wobei der Schätzer ein Vorverarbeitungsmodul zum Ändern einer Abtastrate mindestens eines der empfangenen Signale einschließt, um mit einer Abtastrate mindestens eines anderen der empfangenen Signale übereinzustimmen, optional wobei das Ändern der Abtastrate des mindestens einen der empfangenen Signale ein Up-Sampling des mindestens einen der empfangenen Signale umfasst, oder das Ändern der Abtastrate des mindestens einen der empfangenen Signale ein Down-Sampling des mindestens einen der empfangenen Signale umfasst.

6. System nach einem der Ansprüche 1, wobei die Modellparameter:

aus einer indirekten Messung der durchschnittlichen internen Batterietemperatur gelernt werden; aus Anschlussimpedanzmessungen der Batterie kalibriert werden; oder unter Verwendung von mindestens einem aus einer Nachschlagetabelle, einem parametrischen Modell, einem Dual-Extended-Kalman-Filter und einem Online-Vergleichsprozess aktualisiert werden.

7. System nach Anspruch 1, wobei das thermische Modell durch eine lineare Gleichung definiert ist.

8. System nach Anspruch 1, wobei eine Gleichung, die das thermische Batteriemodell umfasst, einen Widerstandserwärmungsterm und einen Entropieerwärmungsterm einschließt, optional wobei der Widerstandserwärmungsterm proportional zu einem Batteriestrom im Quadrat ist und der Entropieerwärmungsterm proportional zum Batteriestrom ist.

9. Verfahren zum Schätzen der Innentemperatur einer Batterie, wobei das Verfahren Folgendes umfasst:

Bestimmen einer durchschnittlichen Batterietemperatur basierend auf einem Systemeingabesignal, umfassend eine Messung mindestens einer beobachtbaren Größe, die mit der Batterie assoziiert ist, wobei die beobachtbare Größe mindestens eines aus einer Spannung, einem Strom, einer Impedanz, einer Oberflächentemperatur, einem Ladezustand, SOC, und einer Temperatur von Batteriekühlmittel umfasst; und Schätzen eines aktuellen Zustands der Batterie basierend auf dem Systemeingabesignal und dem durchschnittlichen Batterietemperatursignal, wobei das Schätzen unter Verwendung eines thermischen Modells durchgeführt wird, das eine Vielzahl von Modellparametern umfasst, wobei der aktuelle Zustand der Batterie eine interne Temperatur der Batterie umfasst.

10. Verfahren nach Anspruch 9, wobei das Erzeugen der durchschnittlichen Batterietemperatur weiter auf einem zweiten Eingabesignal basiert, umfassend eine indirekte Messung der beobachtbaren Größe, optional wobei das Schätzen des aktuellen Zustands der Batterie weiter auf dem zweiten Eingabesignal basiert, oder die indirekte Messung mindestens einen Ladezustand, SOC, der Batterie, einen Gesundheitszustand, SOH, der Batterie und eine Zellkapazität der Batterie umfasst.

**11.** Verfahren nach einem der Ansprüche 9-10, wobei das thermische Modell ein erweitertes thermisches Modell umfasst, wobei das erweiterte thermische Modell jedes einer Vielzahl von Segmenten der Batterie und thermische Interaktionen zwischen den Batteriesegmenten modelliert.

**12.** Verfahren nach einem der Ansprüche 9-11, wobei das Schätzen unter Verwendung eines Kalman-Filters durchgeführt wird und optional das Verfahren weiter Aktualisieren der Messrauschfehlerstatistik für den Kalman-Filter basierend auf einer aktuellen Schätzung des Batteriezustands umfasst, oder das Schätzen unter Verwendung eines unterabgetasteten Kalman-Filters durchgeführt wird.

**13.** Verfahren nach einem der Ansprüche 9-10, wobei das Schätzen weiter Ändern einer Abtastrate von mindestens einem der empfangenen Signale umfasst, um mit einer Abtastrate von mindestens einem anderen der empfangenen Signale übereinzustimmen, optional wobei das Ändern der Abtastrate des mindestens einen der empfangenen Signale ein Up-Sampling des mindestens einen der empfangenen Signale umfasst, oder das Ändern der Abtastrate des mindestens einen der empfangenen Signale ein Down-Sampling des mindestens einen der empfangenen Signale umfasst.

**14.** Verfahren nach einem der Ansprüche 9-10, weiter umfassend:

Lernen der Modellparameter aus einer indirekten Messung der durchschnittlichen internen Batterietemperatur;
Kalibrieren der Modellparameter anhand von Anschlussimpedanzmessungen der Batterie; oder
Aktualisieren der Modellparameter unter Verwendung von mindestens einem aus einer Nachschlagetabelle, einem parametrischen Modell, einem Dual-Extended-Kalman-Filter und einem Online-Vergleichsprozess.

**15.** Verfahren nach einem der Ansprüche 9-10, wobei das thermische Modell durch eine lineare Gleichung definiert ist, die umfasst, dass das thermische Batteriemodell einen Widerstanderwärmungsterm und einen Entropieerwärmungsterm einschließt, optional wobei der Widerstanderwärmungsterm proportional zu einem Batteriestrom im Quadrat ist und der Entropieerwärmungsterm proportional zu dem Batteriestrom ist.

## Revendications

**1.** Système (100, 200)
pour estimer une température interne d'une batterie, le système comprenant :

un premier circuit (104, 204) pour recevoir un signal (u) d'entrée de système comprenant une mesure d'au moins une grandeur observable associée à la batterie et délivrer en sortie une estimation basée sur une régression d'un signal de température moyenne de batterie sur la base du signal d'entrée de système, dans lequel la grandeur observable comprend au moins un élément parmi une tension, un courant, une impédance, une température de surface, un état de charge, SOC, et une température de réfrigérant de batterie ; et
un estimateur (106, 206) pour recevoir le signal d'entrée de système et le signal de température moyenne de batterie et estimer un état actuel de la batterie sur la base des signaux reçus,
dans lequel l'estimateur comprend un modèle thermique de la batterie comprenant une pluralité de paramètres de modèle, et dans lequel l'état actuel de la batterie comprend une température interne de la batterie.

**2.** Système selon la revendication 1, dans lequel le premier circuit reçoit en outre un second signal d'entrée, le second signal d'entrée comprenant une mesure indirecte de la grandeur observable, le premier circuit délivrant en sortie la température moyenne de batterie sur la base du signal d'entrée de système et du second signal d'entrée, dans lequel la mesure indirecte comprend au moins un élément parmi un état de charge, SOC, de la batterie, un état d'intégrité, SOH, de la batterie, et une capacité d'élément de la batterie, et éventuellement dans lequel l'estimateur reçoit en outre le second signal d'entrée, l'estimateur estimant la température interne de la batterie sur la base du signal d'entrée de système, du signal de température moyenne de batterie et du second signal d'entrée.

**3.** Système selon la revendication 1, dans lequel le modèle thermique comprend un modèle thermique étendu pour modéliser chacun d'une pluralité de segments de la batterie et des interactions thermiques entre les segments de batterie, et dans lequel l'état actuel de la batterie comprend une température interne de chacun de la pluralité de segments.

4. Système selon l'une quelconque de la revendication 1, dans lequel l'estimateur comprend un filtre Kalman, éventuellement dans lequel le filtre Kalman est un filtre Kalman sous-échantillonné, ou des statistiques d'erreur de mesure due au bruit pour le filtre Kalman sont mises à jour sur la base d'une estimation actuelle de l'état de batterie.

5. Système selon la revendication 1, dans lequel l'estimateur inclut un module de prétraitement pour modifier une fréquence d'échantillonnage d'au moins un des signaux reçus pour correspondre à une fréquence d'échantillonnage d'au moins un autre des signaux reçus, éventuellement dans lequel la modification de la fréquence d'échantillonnage de l'au moins un des signaux reçus comprend le suréchantillonnage de l'au moins un des signaux reçus, ou la modification de la fréquence d'échantillonnage de l'au moins un des signaux reçus comprend le sous-échantillonnage de l'au moins un des signaux reçus.

6. Système selon l'une quelconque de la revendication 1, dans lequel les paramètres de modèle :

sont apprises à partir d'une mesure indirecte d'une température interne moyenne de batterie ;
sont étalonnés à partir des mesures d'impédance terminale de la batterie ; ou
sont mis à jour en utilisant au moins un élément parmi une table de consultation, un modèle paramétrique, un filtre Kalman étendu double et un processus de comparaison en ligne.

7. Système selon la revendication 1, dans lequel le modèle thermique est défini par une équation linéaire.

8. Système selon la revendication 1, dans lequel une équation comprenant le modèle thermique de batterie inclut un terme de chauffage par effet Joule et un terme de chauffage à entropie, éventuellement dans lequel le terme de chauffage par effet Joule est proportionnel à un courant de batterie au carré et le terme de chauffage à entropie est proportionnel au courant de batterie.

9. Procédé d'estimation d'une température interne d'une batterie, le procédé comprenant :

la détermination d'une température moyenne de batterie sur la base d'un signal d'entrée de système comprenant une mesure d'au moins une grandeur observable associée à la batterie, dans lequel la grandeur observable comprend au moins un élément parmi une tension, un courant, une impédance, une température de surface, un état de charge, SOC, et une température de réfrigérant de batterie ; et
l'estimation d'un état actuel de la batterie sur la base du signal d'entrée de système et du signal de température moyenne de batterie, dans lequel l'estimation est effectuée en utilisant un modèle thermique comprenant une pluralité de paramètres de modèle,
dans lequel l'état actuel de la batterie comprend une température interne de la batterie.

10. Procédé selon la revendication 9, dans lequel la génération de la température moyenne de batterie est en outre basée sur un second signal d'entrée comprenant une mesure indirecte de la grandeur observable, éventuellement dans lequel l'estimation de l'état actuel de la batterie est en outre basée sur le second signal d'entrée, ou la mesure indirecte comprend au moins un élément parmi un état de charge, SOC, de la batterie, un état d'intégrité, SOH, de la batterie et une capacité d'élément de la batterie.

11. Procédé selon l'une quelconque des revendications 9 à 10, dans lequel le modèle thermique comprend un modèle thermique étendu, le modèle thermique étendu modélisant chacun d'une pluralité de segments de la batterie et des interactions thermiques entre les segments de batterie.

12. Procédé selon l'une quelconque des revendications 9 à 11, dans lequel l'estimation est effectuée en utilisant un filtre Kalman, et éventuellement le procédé comprend en outre la mise à jour de statistiques d'erreur de mesure due au bruit pour le filtre Kalman sur la base d'une estimation actuelle de l'état de batterie, ou l'estimation est effectuée en utilisant un filtre Kalman sous-échantillonné.

13. Procédé selon l'une quelconque des revendications 9 à 10, dans lequel l'estimation comprend en outre la modification d'une fréquence d'échantillonnage d'au moins un des signaux reçus pour correspondre à une fréquence d'échantillonnage d'au moins un autre des signaux reçus, éventuellement dans lequel la modification de la fréquence d'échantillonnage de l'au moins un des signaux reçus comprend le suréchantillonnage de l'au moins un des signaux reçus, ou la modification de la fréquence d'échantillonnage de l'au moins un des signaux reçus comprend le sous-échantillonnage de l'au moins un des signaux reçus.

14. Procédé selon l'une quelconque des revendications 9 à 10, comprenant en outre :

l'apprentissage des paramètres de modèle à partir d'une mesure indirecte d'une température interne moyenne de batterie ;
l'étalonnage des paramètres de modèle à partir de mesures d'impédance terminale de la batterie ; ou
la mise à jour des paramètres de modèle en utilisant au moins un élément parmi une table de consultation, un modèle paramétrique, un filtre Kalman étendu double et un processus de comparaison en ligne.

15. Procédé selon l'une quelconque des revendications 9 à 10, dans lequel le modèle thermique est défini par une équation linéaire comprenant le modèle thermique de batterie qui inclut un terme de chauffage par effet Joule et un terme de chauffage à entropie, éventuellement dans lequel le terme de chauffage par effet Joule est proportionnel à un courant de batterie au carré et le terme de chauffage à entropie est proportionnel au courant de batterie.

$$S_1$$

$$S_2$$

100

102

$u$

$$T_{avg} = f(Z)$$

104

Average Battery
Temperature

Internal
Battery
Temperature
Estimator

106

Internal
Battery
Temperature

**FIG. 1**

**FIG. 2**

FIG. 3

FIG. 4

**FIG. 5**

FIG. 6

EP 4 323 738 B1

800

$\hat{x}_0^+, \Sigma_{\hat{x},0}^+$ Initialization

State Space Model
$x_{k+1} = A_k x_k + B_k u_k$

Measurement Model
$y_k = C_k x_k$

802
$\hat{x}_k^- = A_{k-1}\, \hat{x}_{k-1} + B_{k-1}\, u_{k-1}$

804
$\Sigma_{\hat{x},k}^+ = A_{k-1}\, \Sigma_{\hat{x},k}^+\, A_{k-1} + \Sigma_w$

806
$\hat{y}_k = C_k \hat{x}_k^-$

812
$\Sigma_{\hat{x},k}^+ = (I - L_k)\Sigma_{\hat{x},k}^-$

810
$\hat{x}_k^+ = x_k^- + L_k(y_k - \hat{y}_k)$

808
$L_k = \Sigma_{\hat{x},k}^-\, C_k\, [\, C_k \Sigma_{\hat{x},k}^-\, C_k + \Sigma_v\,]^{-1}$

State, Covariance
Estimates
$\hat{x}, \hat{\Sigma}$

EIS meas.

Yes

No

$L_k = 0$

Prediction

Correction

FIG. 7

900

904

UPDATE MEASUREMENT NOISE STATISTICS

MEASUREMENTS → KALMAN FILTER → STATE ESTIMATE

902

**FIG. 8**

1100

| INPUT DEVICE 1112 | OUTPUT DEVICE 1114 | NETWORK ADAPTER 1116 | ELECTRODES 1115 |

BUS 1106

PROCESSOR 1102

LOCAL MEMORY 1108

BULK STORAGE 1110

INTERNAL BATTERY TEMPERATURE ESTIMATION MODULE 1120

1104

**FIG. 9**

**EP 4 323 738 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016079633 A1